## Europäisches Patentamt
## European Patent Office
## Office européen des brevets

(19)

(11) Numéro de publication: **0 128 055**
**B1**

(12)

# FASCICULE DE BREVET EUROPÉEN

(45) Date de publication du fascicule du brevet:
**13.01.88**

(21) Numéro de dépôt: **84400757.5**

(22) Date de dépôt: **17.04.84**

(51) Int. Cl.⁴: **H 03 H 17/00**, G 11 C 19/28,
G 01 S 13/18

(54) **Dispositif de retard et son utilisation dans le dispositif de décodage d'un équipement de mesure de distance.**

(30) Priorité: **26.04.83 FR 8306828**

(43) Date de publication de la demande:
**12.12.84 Bulletin 84/50**

(45) Mention de la délivrance du brevet:
**13.01.88 Bulletin 88/2**

(84) Etats contractants désignés:
**CH DE GB IT LI NL**

(73) Titulaire: **THOMSON- CSF, 173, Boulevard Haussmann, F-75379 Paris Cédex 08 (FR)**

(72) Inventeur: **Skrzypczak, Jean- Michel, THOMSON- CSF SCPI 173, bld Haussmann, F-75379 Paris Cedex 08 (FR)**

(74) Mandataire: **Benoit, Monique, THOMSON- CSF SCPI 19, avenue de Messine, F-75008 Paris (FR)**

(56) Documents cité:
**US-A-4 152 780**

**ELECTRONICS, vol. 50, no. 2, 20 janvier 1977, New York (US) "The 65-k RAM looms large, but CCDs and bubbles are 'iffy'", pages 94-96**
**IBM TECHNICAL DISCLOSURE BULLETIN, vol. 22, no. 1, juin 1979, New York (US) G. GOERTZEL et al.:"Variable delay line", pages 419-420**

## Description

L'invention concerne un dispositif de retard et son utilisation dans le dispositif de décodage d'un équipement de mesure de distance.

Un système de mesure de distance, objet de la présente invention - autrement appelé D.M.E. soit Distace Measuring Equipment en vocable anglo-saxon - est un équipement d'aide à la navigation aérienne, comportant un équipement interrogateur placé à bord d'un aéronef - avion, ballon ou hélicoptère par exemple - et des transpondeurs placés au sol et dont le rôle est de mesurer la distance oblique entre l'aéronef en vol et les stations DME au sol. Ce système DME appartient au système de navigation à coordonnées polaires, dont les normes sont standardisées par l'Organisation de l'Aviation Civile Internationale (O.A.C.I.).

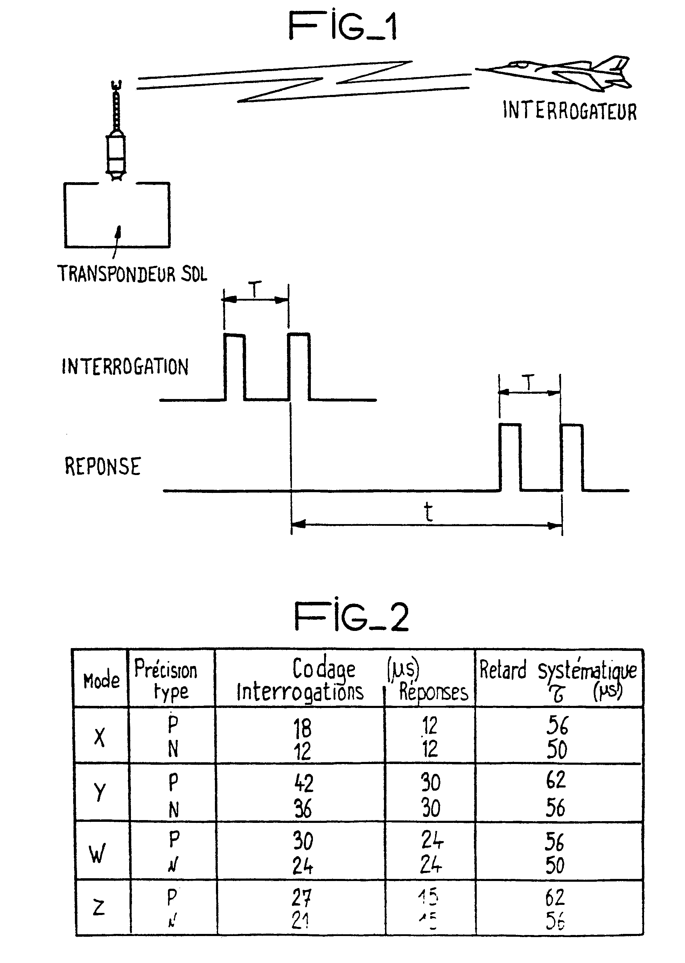

Le principe de fonctionnement d'un système DME est le suivant. L'équipement interrogateur placé à bord de l'aéronef envoie des interrogations aux stations sol, sous la forme de paires d'impulsions espacées d'un temps T définissant ainsi le code d'interrogation. Les stations sol reçoivent les interrogations qui lui sont destinées, sans avoir à connaître leur origine géographique et renvoient des réponses synchrones de l'interrogation, également sous forme de paires d'impulsions caractérisées par un code de réponse T'. En mesurant le retard t entre l'émission de l'interrogation par l'équipement à bord de l'aéronef et la réception de la réponse émise par la station au sol, l'équipement à bord de l'aéronef en déduit la distance oblique entre l'aéronef et la station au sol (figure 1).

Le retard a deux composantes:
- le temps de propagation des paires d'impulsions entre l'aéronef et le sol et vice versa;
- un retard systématique $\tau$ dû au transpondeur au sol et fixé à une valeur constante pour une station donnée, afin que les informations reçues de l'aéronef aient eu le temps d'être traitées. Ainsi la distance oblique D entre l'aéronef et la station sol est donnée par la formule:

$$D = \frac{(t-\tau)}{2} \cdot c$$

avec t = temps s'écoulant entre l'interrogation émise par l'aéronef et la réponse reçue par la station au sol,
et c = vitesse de propagation des informations.

L'objet de la demande concerne plus précisément le transpondeur situé dans la station DME sol. Selon les normes O.A.C.I., la bande de fréquence utilisée pour les émissions dans un système DME est comprise entre 962 MHz et 1213 MHz, subdivisée en canaux de 1 MHz, alloués aux différentes stations DME sol. En plus de cette émission sur un canal particulier, chaque transpondeur peut fonctionner suivant quatre modes différents, appelés modes X, Y, W ou Z et caractérisés eux-mêmes chacun à la fois par un code donné pour les interrogations et le code correspondant pour les réponses et par un retard systématique $\tau$ donné. Chaque mode se subdivise en deux types, correspondant à deux précisions différentes sur la distance D à mesurer: lorsque l'aéronef se trouve jusqu'à 200 miles nautiques ou plus autour de la balise, il utilise des interrogations du type "normal" - N - auxquelles la station sol répondra par des réponses du même type N. L'information de distance oblique entre la station sol et l'aéronef sera donnée avec une précision de l'ordre de 0,25 miles nautiques. D'autre part, si l'aéronef est dans une zone inférieure à 7 miles nautiques autour de la station sol, la précision avec laquelle sera donnée l'information de distance oblique sera meilleure, de l'ordre de 30 mètres, en utilisant des interrogations du type "précision," - p -. La figure 2 représente la table de spécification des différents modes de fonctionnement d'un transpondeur DME, selon les normes O.A.C.I.

Les canaux X et Y sont utilisés par le système DME-N, dit également en route. Les canaux X Y Z, W sont utilisés par le système DME-P, de précision, qui sera essentiellement associé au système d'atterrissage I.L.S. Le dispositif d'interrogation DME-P en mode approche utilise en fonction de la distance D mesurée à bord les modes N ou P (distance D supérieure à 7 miles nautiques pour mode N et distance D inférieure à 7 miles nautiques pour mode P) conformément à la figure 2 et change le codage des impulsions d'interrogation en fonction du mode sélectionné. Ce système à double mode d'interrogation proposé par THOMSON-CSF a été adopté par l'AVOP de l'OACI comme base de principe du fonctionnement du système DME-P.

Ainsi, un aéronef désirant connaître sa distance oblique par rapport à une station DME sol donnée, va émettre des paires d'impulsions en vue de l'interrogation de cette station. La station DME sol ne lui répondra que si elle reconnaît valide l'interrogation qu'elle reçoit, autrement dit:
- si l'interrogation se fait sur le canal qui lui est alloué et
- si le code de l'interrogation, c'est-à-dire l'espacement entre deux impulsions correspond au mode de fonctionnement programmé dans cette station.

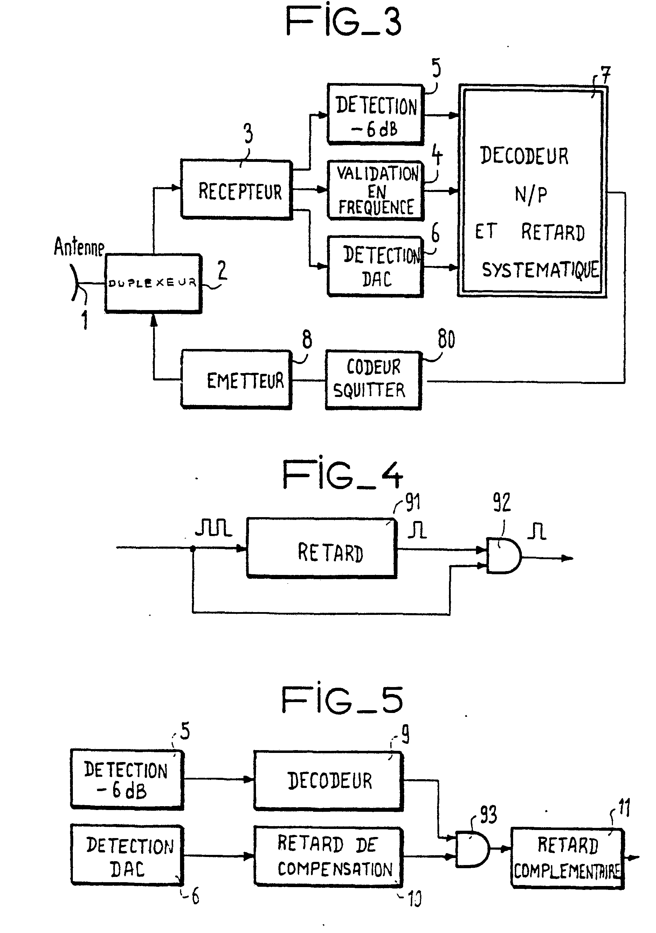

La figure 3 représente le synoptique d'un transpondeur DME placé dans une station sol et dont la description fonctionnelle va suivre. D'après ce qui précéde, le transpondeur DME reçoit les paires d'impulsions d'interrogation en provenance des aéronefs, décode les signaux reçus afin de reconnaître celles qu'il considère comme valides c'est-à-dire celles qui lui sont destinées, déclenche les réponses à l'interrogation en tenant compte du retard systématique, code les réponses avant de fournir les signaux d'émission afin d'avoir le temps de traiter les interrogations reçues.

Pour cela, le transpondeur est constitué par une antenne 1 qui est omnidirectionnelle pour une station DME "en route" utilisée pour la navigation et de préférence directionnelle pour une station DME "atterrissage" - dite DME. P en approche à l'atterrissage, captant les interrogations en provenance de l'aéronef; les signaux reçus de niveau faible ou fort avec une distribution aléatoire, traversent un circuit duplexeur 2 avant de passer dans un circuit récepteur 3 qui, après amplification et détection, délivre les paires d'impulsions d'interrogation sous forme vidéo. Pour une bonne exploitation de ces informations vidéo, les impulsions passent à travers trois circuits 4, 5 et 6 de traitement avant d'être reconnues valides et retardées par un circuit 7, objet de notre demande. Enfin, le transpondeur DME comporte un circuit 80 de codage des réponses à destination du circuit 8 d'émission; ces réponses passent ensuite dans le duplexeur 2 avant d'être envoyées par l'antenne 1.

Les informations vidéo, en sortie du circuit récepteur 3, sont constituées par un grand nombre d'impulsions, les unes correspondant aux interrogations valides, c'est-à-dire ayant le bon espacement correspondant à la station DME sol considérée, les autres correspondant aux interrogations destinées à des stations DME sol voisines n'ayant pas le même mode et d'autres aussi correspondant aux échos multitrajets, qui peuvent eux-mêmes fortement perturber des interrogations valides. Ces informations vidéo étant utilisées pour déterminer la distance entre un avion et une station sol, il est important d'échapper aux erreurs qui naîtraient d'une modification du signal d'interrogation reçu due à des parasites. Aussi, pour exploiter ces informations vidéo le plus sûrement possible, on utilise trois circuits dont l'un, le circuit 4, a pour rôle de valider en fréquence de réception les impulsions vidéo. Le récepteur 3 a une voie fréquence intermédiaire large bande, de l'ordre de 4 MHz, pour laisser passer les impulsions ayant un front de montée rapide, ce qui a pour conséquence de prendre plusieurs canaux adjacents en considération et donc de mélanger les interrogations valides à celles des canaux voisins. Le circuit 4 ne valide que les interrogations reçues sur la bonne fréquence du canal correspondant à la station DME sol considérée.

Le second circuit 5 est un circuit de détection de temps d'arrivée des impulsions, à - 6 décibels (dB) en-dessous de la valeur crête des impulsions reçues par le transpondeur. La sortie de ce circuit est utilisée pour traiter les interrogations de type N et pour vérifier le codage des impulsions d'interrogation.

Enfin, le troisième circuit 6 est un circuit de détection de l'instant d'arrivée de la première impulsion d'une paire d'interrogation du type P. L'instant d'arrivée d'une telle impulsion doit être connu avec précision et doit échapper aux erreurs dues à la deformation de cette impulsion par son propre écho car il est important pour le pilote de l'aéronef de connaître avec la meilleure précision possible la distance de l'aéronef par rapport au sol. Donc la détection de l'instant d'arrivée de la première impulsion doit se faire le plus rapidement possible avant sa déformation. Pour cela on utilise un circuit connu sous le nom de D.A.C. -"Delay and Compare" en vocable anglo-saxon - dont le fonctionnement basé sur un retard et une comparaison est décrit dans la demande de brevet français, publié au nom de la Demanderesse, FR-A-2 497 958.

Lorsque les impulsions reçues par le transpondeur DME ont été mises en forme par les trois circuits précédents, elles passent dans le circuit 7 dont la fonction est double puisqu'il décode les paires d'impulsions pour identifier les interrogations valides et introduit un retard $\zeta$, constant et fixé à une valeur donnée pour la station sol permettant de traiter les informations reçues.

Ensuite, le transpondeur DME répond à l'avion en émettant des signaux constitués par des paires d'impulsions, codées par un circuit codeur 80 selon le mode de fonctionnement de la station, et par des impulsions codées en provenance d'un circuit, appelé "squitter" en vocable anglo-saxon, dont le rôle est de maintenir une cadence minimum d'émission pseudo-aléatoire sur l'émetteur. Le rôle du squitter est essentiellement de maintenir un taux de charge constant pour l'émetteur; pour cela, si le nombre de réponses à des interrogations réelles diminue, le nombre de paires d'impulsions générées par le squitter augmente et vice versa. Enfin, le circuit d'émission 8 assure la génération des signaux qui seront appliqués sur l'antenne 1.

L'objet de l'invention portant sur le circuit décodeur 7, nous allons successivement exposer le principe de décodage des impulsions d'interrogation reçues par le transpondeur DME au sol et décrire les différents modes de réalisation de décodeurs déjà existants.

La figure 4 représente le schéma de principe d'un décodeur. Le principe du décodage est le suivant: on retarde dans un circuit 91 la première impulsion de la paire reçue par le transpondeur d'un temps égal au code à reconnaître - le code étant représenté par l'espacement entre la première et la deuxième impulsion - puis on compare le signal obtenu en sortie du circuit de retard avec le signal non retardé; la comparaison peut se faire à l'aide d'une porte ET 92. Si la paire d'impulsions ainsi traitée présente le bon code, il y a coïncidence entre la deuxième impulsion et la première impulsion en sortie du circuit de retard. Pour compléter la description du transpondeur, il faut exposer brièvement le principe du décodage associé au retard systématique, dont la figure 5 donne le schéma. On a dit précédemment que le décodage se faisait à partir d'un signal détecté à - 6 dB en-dessous de la valeur crête, c'est pourquoi le circuit décodeur 9 est connecté à la sortie du circuit 5 de détection àdB. Lorsque le circuit décodeur 9 a identifié l'interrogation envoyée par l'aéronef l'a reconnue conforme au mode de la station DME sol, il valide les impulsions en sortie d'un premier circuit 10 de retard de compensation à l'aide d'une porte ET 93 par exemple. Le circuit 10 est connecté à la sortie du circuit 6 de détection D.A.C. qui donne avec précision l'instant d'arrivée de la première impulsion de la paire servant à l'interrogation DME-P. Le retard de compensation est égal au temps $R_c$ utilisé pour le décodage des impulsions et est donc destiné à compenser le temps nécessaire pour vérifier le codage de l'interrogation. Les impulsions ainsi validées passent ensuite dans un circuit 11 de retard $R_{co}$ complémentaire, qui ajouté au retard de compensation, donne le retard systématique $\zeta$:

$$\zeta = R_c + R_{co}$$

Actuellement, il existe différentes solutions au problème posé par la grande précision imposée pour le décodage des impulsions d'interrogation et pour le retard systématique $\zeta$. Cette précision doit être plus grande dans le type P "précision" des interrogations mais les solutions qui vont être décrites par la suite et qui conviennent au type P doivent convenir également au type N.

Etant donné les précisions demandées pour le retard systématique, d'une part:

± 200 ns pour les interrogations du type N et

± 30 ns pour les interrogations du type P

> et les variations du retard $R_c$ nécessaire au temps de décodage, et qui doit être programmable en fonction du mode de la station, d'autre part:

12 µs pour le mode X, type N et

42 µs pour le mode Y, type P, le problème consiste alors à réaliser un retard de précision de ± 30 ns pouvant atteindre 42 µs, en mode Y, type P.

Une des solutions actuellement utilisée consiste à retarder les impulsions d'interrogation par un registre à décalage à plusieurs étages, composé d'un nombre N de circuits de mémorisation montés en série et commandés par une même horloge, c'est-à-dire un signal périodique de période $T_e$. Le retard maximum obtenu avec N étages est égal à N. $T_e$ avec une résolution égale à $T_e$. Le retard ainsi réalisé devant être programmable, donc composé à partir d'un nombre d'étages variable, on doit utiliser des registres réalisés soit en technologie dite T.T.L. (Transistor-Transistor-Logic) soit en technologie dite M.O.S. (Metal Oxide Semiconductor).

Les inconvénients de cette solution proviennent des limitations propres aux deux technologies. La précision exigée pour les interrogations du type P ( ± 30 ns) implique une fréquence de l'horloge élevée or, en technologie MOS, la fréquence ne dépasse pas 20 MHz et ne permet donc pas d'obtenir la résolution demandée. En ce qui concerne la valeur du retard R à réaliser, elle implique un nombre considérable de boîtiers intégrés constituant chaque registre, notamment en technologie T.T.L.

Une autre solution également connue consiste à utiliser un circuit de retard composé de chaînes de compteurs disposées en parallèle. Le rendement d'un tel système, c'est-à-dire le nombre d'impulsions en sortie par rapport au nombre d'impulsions en entrée, dépend du nombre des compteurs mis en parallèle. La limitation du nombre de chaînes entraîne une tendance à la saturation du circuit de retard qui devient vite indisponible, d'autant plus si les multitrajets ou d'autres interrogations de code différents sont nombreux.

Le but de la présente invention est de pallier ces différents inconvénients en réalisant un circuit de retard d'un signal électrique, tel que défini dans la revendication 1.

D'autres caractéristiques et avantages de l'invention apparaîtront dans la description qui suit, illustrée par les figures suivantes qui, outre les figures 1 à 5 déjà décrites et concernant l'art antérieur, représentent:

- la figure 6: le schéma synoptique du circuit de retard, objet de l'invention;

- la figure 7: les moyens d'acquisition du circuit de retard selon l'invention;

- la figure 8: les moyens de mémorisation du circuit de retard selon l'invention;

- la figure 9: les moyens de restitution du circuit de retard selon l'invention;

- la figure 10: le diagramme temporel pour le retard d'une impulsion passant dans le circuit de retard selon l'invention.

Les éléments assurant les mêmes fonctions en vue des mêmes résultats dans les différentes figures portent les mêmes références.

Le circuit de retard selon l'invention va être décrit dans son application à un dispositif de décodage d'un système DME.

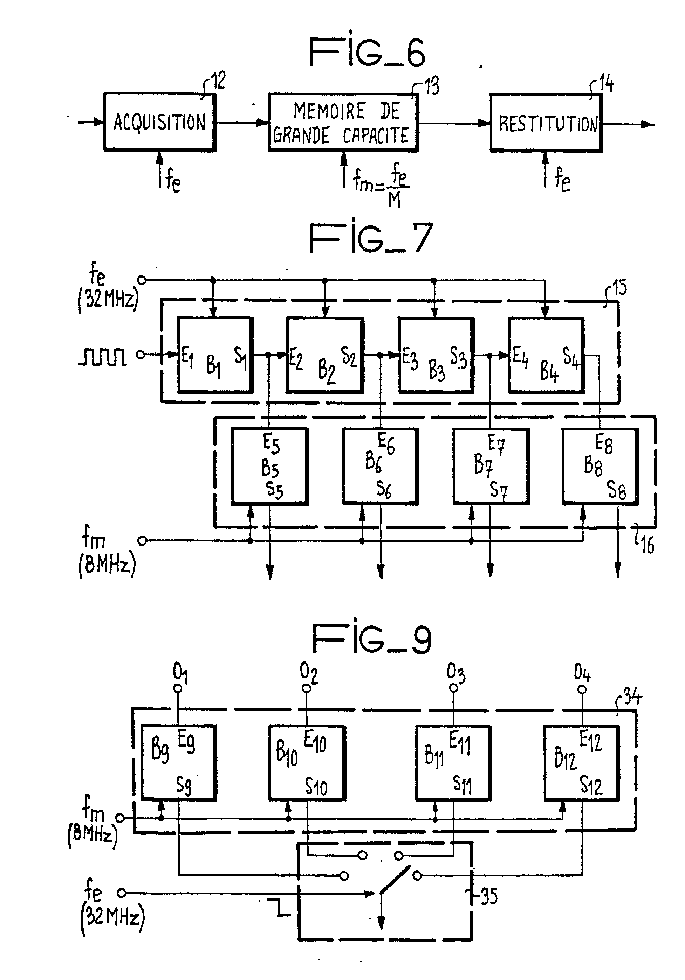

Comme le montre la figure 6, qui représente le schéma synoptique du circuit de retard selon l'invention, ce dernier peut se décomposer en trois systèmes 12, 13 et 14 ayant pour fonctions respectives l'acquisition des informations à retarder, leur mémorisation pendant une durée déterminée et enfin leur restitution, étant donné que l'acquisition et la restitution ont lieu à une fréquence élevée $f_e$ alors que la propagation de l'information mémorisée se fait à une fréquence plus basse $f_m$. Ainsi le principe du circuit de retard selon l'invention repose sur un changement de fréquence d'horloge entre les moyens d'acquisition et de restitution d'une part et les moyens de mémorisation pour retarder d'autre part.

Il est nécessaire que le moins d'erreur possible soit introduit dans le retard appliqué aux impulsions d'entrée du code de précision. Pour mémoriser les informations en vue de les retarder, les impulsions d'entrée doivent être échantillonnées. En échantillonnant le signal DME d'entrée à une fréquence minimale de 32 MHz, l'erreur due à la non synchronisation des impulsions du signal DME avec les impulsions de l'horloge correspond à une période de ce signal, donc est inférieure à 32 ns. Ce qui correspond à la résolution nécessaire à l'obtention de la précision exigée ( ± 30 ns) avec les interrogations du type P. Cette fréquence $f_e$ égale à 32 MHz est un exemple non limitatif de fréquence d'échantillonnage.

De plus, les retards importants que doivent subir les impulsions imposent des moyens de mémorisation des informations de grande capacité avec un minimum de composants. Pour cette raison on emploie des mémoires à accès aléatoire adressables - RAM (Random Access Memory) - , qui sont des mémoires vives dans lesquelles on peut lire et écrire à une adresse quelconque.

L'échantillonnage est fait de telle sorte qu'à chaque période d'horloge, on écrit un signal échantillonné en mémoire. A chaque période d'horloge, on procéde également à la lecture d'une information, qui est située à une adresse précédente et qui a été écrite antérieurement.

Pour obtenir un retard de 42 us, il faut une mémoire RAM d'au moins 1344 bits. Or une telle RAM ne se trouve pas couramment dans le commerce. De plus, le temps d'accès à une adresse d'une telle mémoire RAM - entre 40 ns et 60 ns - entraîne une fréquence $f_m$ d'horloge appliquée à la mémoire RAM égale au maximum à 8 MHz, valeur limite qui correspond à un temps d'adressage de 125 ns. Cette fréquence $f_m$ est obtenue par simple division de la fréquence $f_e$, donc les deux horloges sont synchrones.

Pour conserver la fréquence d'échantillonnage $f_e$ initiale à 32 MHz, il faut démultiplexer le signal vidéo DME d'entrée vers quatre mémoires RAM de 1024 bits chacune, mises en parallèle, travaillant à une fréquence $f_m$ égale à 8 MHz. Les informations lues simultanément sur ces quatre RAM seront ensuite multiplexées vers la sortie.

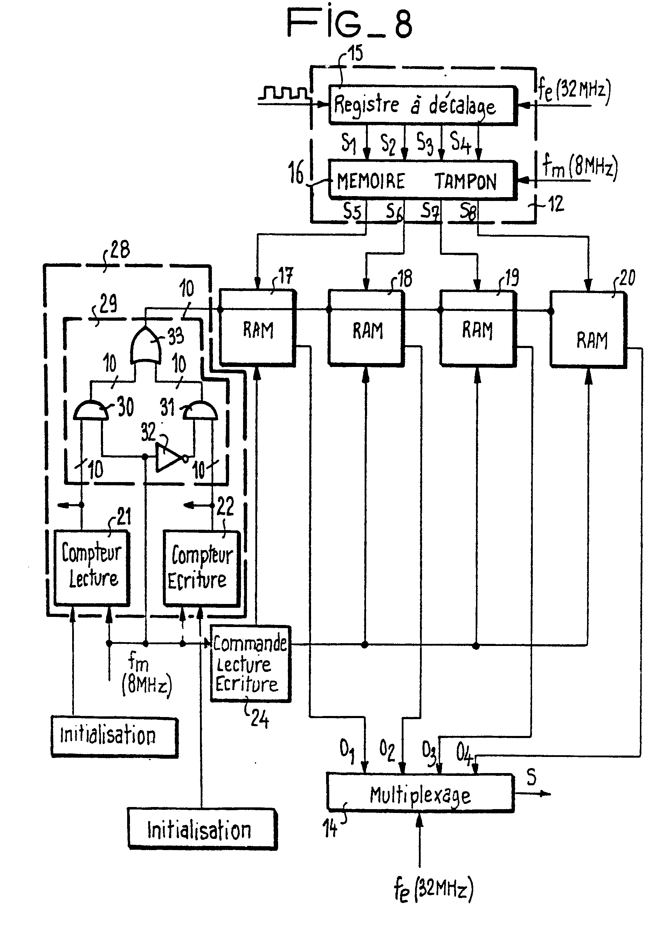

Les moyens d'acquisition, représenté sur la figure 7, ont pour fonction d'échantillonner les informations arrivant sous forme d'impulsions en série et de les convertir en mots binaires de 4 bits, puis de les mémoriser temporairement. Pour cela, ils sont constitués par un registre à décalage 15 de quatre étages en technologie T.T.L. commandés par un premier signal de fréquence $f_e$ égale à 32 MHz et dont le rôle est d'échantillonner le signal DME avec une résolution de 31, 25 ns puis de le convertir en un mot binaire sur quatre bits. Les sorties parallèles de ce registre à décalage sont connectées aux entrées parallèles de quatre circuits de mémorisation $B_5$ à $B_8$ - des bascules par exemple - montées en parallèle servant de mémoire tampon, commandées par un même premier signal de fréquence $f_m$ quatre fois plus faible que $f_e$, synchrone avec le premier signal de fréquence $f_e$ et destinnes à stocker temporairement chaque mot binaire pendant 125 ns.

Le registre à décalage 15 est constitué de quatre bascules $B_1$ à $B_4$, montés en série et commandées par un même signal de fréquence $f_e$. Ainsi, le signal DME arrive sous forme d'impulsions à l'entrée $E_1$, de la première bascule $B_1$ du registre à décalage 15. A chaque pas de l'horloge $H_1$, de fréquence $f_e = 32$ MHz correspondant à une période de 31, 25 ns, les impulsions progressent vers les autres bascules

$B_2$ à $B_4$. Au quatrième pas d'horloge, les quatre bascules $B_1$ à $B_4$ ont en mémoire, sur chacune de leurs sorties $S_1$ à $S_4$, une information sous forme de bits qui apparaît également sur chacune des entrées $E_5$ à $E_8$ des quatre autres bascules $B_5$ à $B_8$ de la mémoire tampon 16; Au premier pas de l'horloge $H_2$, de fréquence $f_m = 8$ MHz, les bascules $B_5$ à $B_8$ mémorisent ces mots binaires qui vont y rester jusqu'au pas de l'horloge $H_2$. Jusqu'au septième pas d'horloge $H_1$ suivant, les informations suivantes du signal DME vont être transmises de la bascule $B_1$ à la bascule $B_4$ sans être memorisées das la mémoire tampon 16, par contre au huitième pas de l'horloge $H_1$, ces informations apparaissat sur les sorties $S_1$ à $S_4$ du premier registre 15 sous forme de mots binaires vont être mémorisées à leur tour dans la mémoire 16. Cette fonction mémoriation a pour but de rendre les informations mises sous forme de mots binaires de 4 bits stables en sortie de la mémoire tampon 16. Sur les sorties $S_1$ à $S_4$ des quatre bascules du premier registre 15, elles changent toutes les 31, 25 ns tandis que sur les sorties $S_5$ à $S_8$ de la mémoire tampon 16, elles ne chagent que toutes les 125 ns, qui représentent une période de l'horloge $H_2$.

Comme on l'a vu précédemment, le circuit de retard selon l'invention comporte des moyens de mémoriation de grandé capacité, constitués d'une part de quatre mémoires RAM 17, 18, 19 et 20. Dans l'exemple particulier de réalisation choisi, elles ont chacune 1024 lignes ce qui donne une capacité totale de 4096 bits. Ces moyens de mémorisation, représentés sur la figure 8, sont connectés d'une part aux moyens d'acquisition 12 et d'autre part aux moyens de restitution 14 des informations. Les quatre mémoires RAM sont connectées en parallèle, les entrées de chacune d'elles étant connectées respectivement aux quatre sorties parallèles $S_5$ à $S_8$ des moyens d'acquisition. Elles sont de plus commandées par un même deuxième signal de fréquence $f_m$ synchrone avec le premier signal de fréquence $f_m$.

Les moyens de mémorisation comprennent d'autre part un circuit d'adressage 28 desdites mémoires RAM, commandé par un troisième signal de fréquence $f_m$ synchrone avec les précédents et présentant à chacune d'elles, à chaque période $T_m$ dudit signal de commande, une adresse de lecture a et une adresse d'écriture a' distincte. Ils comprennent enfin un circuit de commande 24 de lecture et d'écriture des mots binaires apparaissant en sortie des moyens d'acquisition 12, commandé par un signal de fréquence $f_m$, synchrone avec le signal de commande précédent et connecté à chacune des RAM.

Le circuit d'adressage 28 est constitué par deux compteurs 21 et 22, respectivement de lecture et d'écriture, initialisés chacun à une valeur telle que la différence entre l'adresse d'écriture d'une information et celle de lecture de cette même information peut atteindre jusqu'à 1023 périodes $T_m$ du signal de commande des compteurs. Cela permet un retard maximum possible d'environ 127 µs. Le circuit d'adressage comporte également un circuit d'aiguillage 29 des adresses de lecture et d'écriture, recevant en entrée les adresses issues des deux compteurs 21 et 22 et délivrant en sortie une de ces deux adresses à chacune des mémoires RAM. Dans un exemple particulier de réalisation, ce circuit d'aiguillage 29 peut être constitué de deux portes ET 30 et 31, d'un inverseur 32 et d'une porte OU 33. Une première porte ET 30 reçoit en entrée l'adresse issue du compteur de lecture 21 et le signal de commade de fréquence $f_m$; la deuxième porte ET 31 reçoit l'adresse issue du compteur d'écriture 22 et le signal de fréquence $f_m$ après passage dans l'inverseur 32 et la porte OU 33 reçoit en entrée les signaux de sortie des deux portes ET respectives pour délivrer une des deux adresses de lecture ou d'écriture.

Le fonctionnement des moyens de mémorisation est le suivant. Soit un mot binaire de quatre bits se présentant sur les sorties $S_5$ à $S_8$ des moyens d'acquisition, a un instant t. Les signaux de commande de fréquence $f_e$ pour les moyens d'acquisition et de restitution et de fréquence $f_m$ pour les moyens dè mémoriation étant synchrones, à cet instant t le circuit de commande 24 envoie un ordre d'écriture à chacune des mémoires RAM et le compteur décriture 22 fournit une adresse a à laquelle va être stockée dans les mémoires RAM ce mot binaire. A un instant t' = n. $T_m$, le compteur de lecture 21 fournit la même adresse a et le circuit de commande 24 envoie un ordre de lecture du même mot binaire. Il y a donc un retard égal à n fois la période $T_m$ du signal de commande des mémoires RAM entre l'écriture et la lecture d'un même mot binaire. C'est en fixant la valeur de n que l'on peut ajuster ce retard. La résolution obtenue est égale à $T_m$ = 125 ns. Le principe d'accès des mémoires RAM permet d'accéder à une ligne quelconque pour y lire ou écrire une donnée. Dans l'exemple de réalisation choisi, chaque ligne des quatre mémoires 17 à 20 porte un numéro d'ordre compris entre 0 et 1023 qui constitue l'adresse de la ligne. Pour cette raison l'adresse de chaque ligne parvient aux mémoires par l'intermédiaire d'un bus à 10 bits. Dans le cas de l'invention, le circuit d'adressage 28 est relié aux quatre mémoires simultanément de sorte que globalement chaque adresse donne accès à un mot de quatre bits.

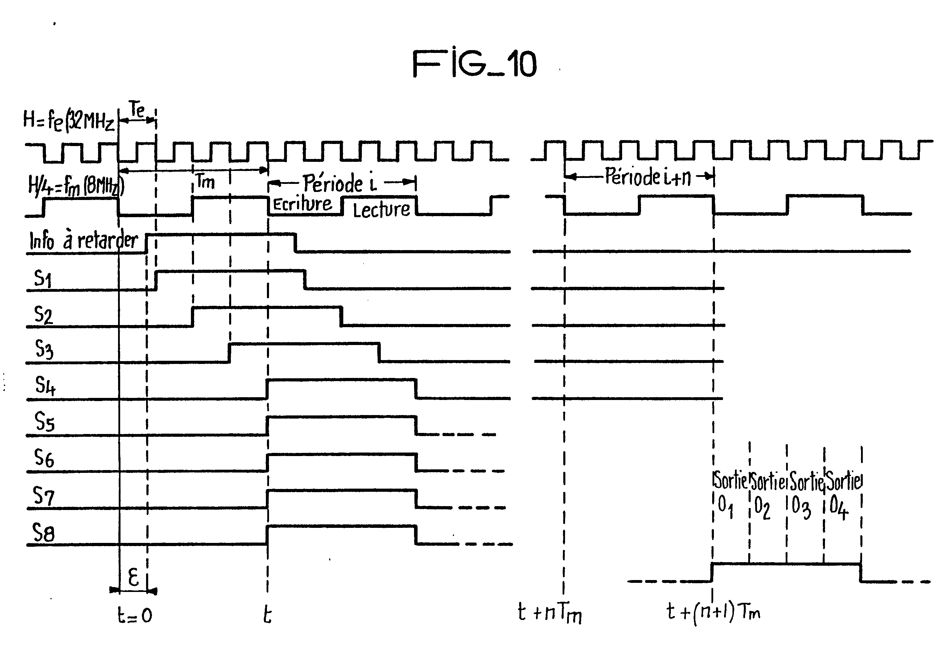

Le schéma de fonctionnement de ces moyens de résritution est donnné par la figure 9. Il comporte un régistre à décalage 34 composé de quatre bascules $B_9$ à $B_{12}$ mises en parallèle et commandées par un troisième signal de fréquence $f_m$ = 8 MHz. L'entrée $E_9$ à $E_{12}$ de chacune des bascules $B_9$ à $B_{12}$ est connectée à la sortie $0_1$ à $0_4$ de chacune des mémoires RAM des moyens de mémorisation 13 précédemment décrits et chacune de leurs sorties $S_9$ à $S_{12}$ est réliée à un circuit multiplexeur 35, fonctionnant à la fréquence $f_e$ = 32 MHz.

Durant la phase lecture, apparaît en sortie des moyens de mémorisation 13 un nombre binaire qui est alors mémorisé par les quatre bascules du registre à décalage 34 jouant le rôle de mémoire tampon pendant une période $T_m$ du signal de commande soit 125 ns suivantes, l'ordre de mémorisation correspondant au front qui délimite la fin de la phase de lecture. Le multiplexeur 35 fonctionnant avec une période de 31, 25 ns explore tour à tour les quatre sorties des bascules, multiplexant ainsi le signal de sortie retardé.

La figure 10 représente un exemple de diagramme temporel du circuit de retard objet de l'invention. Le signal H représente le signal d'échantillonnage, de fréquence $f_e$ égale à 32 MHz, du signal DME d'entrée se présentant sous forme de paires d'impulsions. Le signal suivant H/4 correspond à un des signaux de commande de fréquence $f_m$ égale au quart de $f_e$, soit 8 MHz dans l'exemple choisi, ces signaux étant synchrones avec le précédent. On constate que sa période $T_m$ est quatre fois supérieure à celle $T_e$ du signal de fréquence $f_e$. En dessous est représentée l'information à retarder, c'est à dire la première impulsion d'une paire d'interrogation. On peut remarquer que celle-ci n'étant pas obligatoirement synchrone avec les précédents signaux, elle peut présenter un décalage ε entre son instant d'arrivée et le début de la période $T_e$ du signal H la plus proche. Ensuite sont représentés les quatre signaux apparaissant sur les quatre sorties $S_1$ à $S_4$ en parallèle du registre à décalage 15 et les quatre signaux apparaissant à une période i donnée du signal H/4, en sortie $S_5$ à $S_8$ de la mémoire tampon 16 constituant les moyens d'acquisition du circuit de retard. Enfin est représentée l'information retardée après un nombre de période apparaissant sur les sorties $0_1$ à $0_4$ en parallèle des quatre mémoires RAM constituant les moyens de mémorisation. A la seconde demi-période i + n, èst donné l'ordre de lecture du mot binaire de quatre bits mémorisé au cours de la période i et c'est à l'instant t + (n + 1) $T_m$ que ce mot est mis dans le registre à décalage 29 des moyens de restitution. On constate que le retard introduit par le circuit de retard selon l'invention est donné par l'expression suivante:

$$R = (n + 2)T_m - ε$$

$$avec\ 0 \leqslant ε < T_e$$

où: n correspond au décalage programmé des adresses de lecture et d'écriture des mémoires,

$$T_m = \frac{1}{f_m} = 125\ ns$$

$$T_e = \frac{1}{f_e} = 31,25\ ns$$

Le retard est ainsi obtenu avec une résolution de 31,25 ns et le retard maximum que l'on peut obtenir avec des moyens de mémorisation de 4096 bits est:

$$R_{max} = (n+2)T_m - \varepsilon$$

soit avec n = 1023

$$R_{max} = 128,125\ \mu s - \varepsilon$$

d'où $128,093\ \mu s < R_{max} < 128,125\ \mu s$.

Le circuit de retard selon l'invention est bien adapté au problème à résoudre dans le cadre du décodeur DME et du retard systématique. En effet, il permet d'obtenir des retards longs avec une bonne résolution. Les valeurs choisies dans notre application (à savoir $f_e = 32$ MHz, $f_m = 8$ MHz, M = 4) ne sont pas les seules possibles.

Cette demande de brevet concernant un circuit de retard de précision permet de réaliser un décodeur DME-P ainsi que le retard systématique.

## Revendications

1. Dispositif de retard d'un signal électrique comportant:
- des moyens d'acquisition (12) du signal électrique, l'échantillonnant à une fréquence $f_e$ donnée et le délivrant en parallèle sous forme de mots binaires à M bits, à une fréquence $f_m$ telle que:

$$f_m = \frac{f_e}{M};$$

- des moyens de mémorisation (13) du signal électrique mis sous forme de mots binaires à M bits, admettant et rejetant l'information à la fréquence $f_m$;
- des moyens de restitution (14) du signal électrique à la fréquence $f_e$, à partir des mots binaires de M bits issus en parallèle des moyens de mémorisation (13) à la fréquence $f_m$; caractérisé en ce que les moyens de mémorisation (13) fournissent les mots binaires aux moyens de restitution (14) avec un retard égal a un nombre entier n de periodes $\frac{1}{f_m}$, les moyens de mémorisation (13) comportant des moyens de programmation du nombre entier n, la longueur du retard étant ainsi programmable.

2. Dispositif de retard selon la revendication 1, caractérisé en ce que les moyens d'acquisition (12) du signal sont constitués par:
- un registre à décalage à M étages, comportant M circuits de mémorisation connectés en série, commandés par un même signal de fréquence $f_e$ donnée, dont le rôle est d'échantillonner le signal électrique et de le convertir en mots binaires de M bits chacun;
- une mémoire tampon à M étages, comportant M circuits de mémorisation connectés en parallèle, commandés par un même signal de fréquence $f_m$, telle que: $f_m = \frac{f_e}{M}$.
Ce signal de fréquence $f_m$ étant de plus synchrone avec le signal de fréquence $f_e$ et les entrées parallèles des M circuits de mémorisation de la mémoire tampon étant reliées respectivement aux sorties des M circuits de mémorisation du registre à décalage, cette mémoire tampon stockant temporairement chaque mot binaire de M bits transitant entre le registre à décalage et les moyens de mémorisation du dispositif de retard.

3. Dispositif de retard selon la revendication 1 ou 2, caractérisé en ce que les moyens de mémorisation (13) du signal sous forme de mots binaires de M bits comprennent:
- M mémoires à accès aléatoire adressables, connectées en parallèle, commandées par un même signal de fréquence $f_m$, synchrone avec les signaux de commande des moyens d'acquisition, les entrees de chacune des mémoires étant connectées respectivement aux M sorties parallèles des moyens d'acquisition;
- un circuit d'adressage (28) desdites mémoires à accès aléatoire, commandé par un signal de fréquence $f_m$ synchrone avec le signal de commande précédent et présentant à chacune d'elles à chaque période dudit signal de commande, une adresse a de lecture et une adresse à d'écriture distincte;
- un circuit de commande (24) de lecture et d'écriture des mots binaires apparaissant en sortie des moyens d'acquisition (12), commandé par un signal de fréquence $f_m$, synchrone avec le signal de commande précédent, et connecté à chacune des mémoires.

4. Dispositif de retard selon l'une quelconque des revendication 1, 2 ou 3, caractérisé en ce que le circuit d'adressage (28) est constitue par:
- un compteur de lecture (21),
- un compteur d'écriture (22),
initialisés chacun à une valeur telle que la différence entre l'adresse d'écriture d'un mot binaire et celle de sa lecture est égale à un nombre donné de périodes du signal de commande,
- un circuit d'aiguillage (29) des adresses de lecture et d'écriture, recevant en entrée les adresses issues des deux compteurs et délivrant en sortie, une seule de ces deux adresses à chacune des mémoires.

5. Dispositif de retard selon l'une quelconque des revendications I, 2, 3 ou 4, caractérisé en ce que le circuit d'aiguillage (29) est constitue par:
- une première porte ET (30) recevant en entrée l'adresse du compteur de lecture (21) et le signal de commande de fréquence $f_m$;
- une deuxième porte ET (31) recevant en entrée l'adresse issue du compteur d'écriture (22) et le signal de fréquence $f_m$ après passage dans un circuit inverseur (32);
- une porte OU (33) recevant en entrée les signaux de sortie des deux portes ET (30) et (31) et délivrant en sortie une des adresses de lecture ou d'écriture.

6. Dispositif de retard selon l'une des revendications 1 à 5, caractérisé en ce que les moyens de restitution (14) du signal sont constitués par:
- un registre à décalage (34) à M étages, comportant M circuits de mémorisation connectés en parallèle, commandés par un même signal de fréquence $f_m$ synchrone avec les signaux de commande précédents les entrées des M circuits de mémorisation étant connectées respectivement aux M sorties parallèles des moyens de mémorisation, dont le rôle est celui d'une mémoire tampon;

- un multiplexeur (35) commandé par un signal issu de fréquence $f_e$ synchrone avec le signal de commande précédent, dont les M entrées sont connectées respectivement aux sorties des M circuits de mémorisation dudit registre à décalage (34) et dont la sortie délivre le signal électrique.

7. Application du dispositif de retard selon l'une des revendications 1 à 6, à un dispositif de décodage (7) d'un transpondeur faisant partie d'un équipement de mesure de distance, caractérisé en ce que:
- la fréquence $f_e$ est égale à 32 MHz,
- la fréquence $f_m$ est égale à 8 MHz,
- le nombre M est égal à 4.

**Patentansprüche**

1. Vorrichtung zur Verzögerung eines elektrischen Signals mit:
- Mitteln zur Erfassung (12) des elektrischen Signals, die es mit einer vorgegebenen Frequenz $f_e$ abtasten und es parallel in Form von Binärwörtern mit M Bits mit einer Frequenz $f_m$ ausgeben, wobei:

$$f_m = \tfrac{f_e}{M};$$

- Mitteln (13) zum Speichern des elektrischen Signals in Form von Binärwörtern mit M Bits, die die Information mit der Frequenz $f_m$ aufnehmen und ausgeben;
- Mitteln (14) zur Wiederherstellung des elektrischen Signals mit der Frequenz $f_e$, ausgehend von Binärwörtern mit M Bits, die parallel von den Speichermitteln (13) mit der Frequenz $f_m$ ausgegeben werden;
dadurch gekennzeichnet, daß die Speichermittel (13) die Binärwörter an die Mittel zur Wiederherstellung (14) mit einer Verzögerung ausgeben, die gleich einem ganzzahligen Vielfachen von Perioden $\tfrac{1}{f_m}$ ist, wobei die Speichermittel (13) Mittel zur Programmierung der ganzen Zahl n enthalten, wodurch die Verzögerungsdauer programmierbar ist.

2. Verzögerungsvorrichtung nach Anspruch 1, dadurch gekennzeichnet, daß die Signalerfassungsmittel (12) durch folgende Bestandteile gebildet werden:.
- ein Schieberegister mit M Stufen, das M in Reihe geschaltete Speicherkreise enthält, die von demselben Signal mit der gegebenen Frequenz $f_e$ geschalten werden, dessen Aufgabe es ist, das elektrische Signal abzutasten und in Binärwörter mit jeweils M Bits umzuwandeln;

- einen Pufferspeicher mit M Stufen, der M parallelgeschaltete Speicherkreise enthält, die vom selben Signal mit der Frequenz $f_m$ gesteuert werden, für die gilt:

$$f_m = \tfrac{f_e}{M},$$

wobei das Signal mit der Frequenz $f_m$ außerdem mit dem Signal der Frequenz $f_e$ synchron ist und die parallelen Eingänge der M Speicherkreise des Pufferspeichers jeweils mit den Ausgängen der M Speicherkreise des Schieberegisters verbunden sind, wobei der Pufferspeicher jedes Binärwort mit M Bits zwischenspeichert, das vom Schieberegister zu den Speichermitteln der Verzögerungsvorrichtung läuft.

3. Verzögerungsvorrichtung nach Anspruch 1 oder 2, daurch gekennzeichnet, daß die Mittel (13) zur Speicherung des Signals in Form von Binärwörtern mit M Bits folgende Bestandteile enthalten:
- M parallelgeschaltete RAM-Speicher, die vom selben Signal mit der Frequenz $f_m$ gesteuert werden, das synchron mit den Steuersignalen der Erfassungsmittel ist, wobei die Eingänge jedes der Speicher jeweils mit den M parallelen Ausgängen der Erfassungsmittel verbunden ist;
- eine Adressierungsschaltung (28) für die RAM-Speicher, die durch ein Signal mit der Frequenz $f_m$ gesteuert wird, das mit dem vorherigen Steuersignal synchron ist und jedem von ihnen in jeder Periode dieses Steuersignals eine Leseadresse und eine unterschiedliche Schreibadresse zuführt;
- eine Steuerungsschaltung (24) zum Lesen und Schreiben der Binärwörter, die am Ausgang der Erfassungsmittel (12) auftreten, die von einem Signal mit der Frequenz $f_m$ gesteuert wird, das mit dem vorherigen Steuersignal synchron ist, und die mit jedem der Speicher verbunden ist.

4. Verzögerungsvorrichtung nach einem der Ansprüche 1, 2 oder 3, dadurch gekennzeichnet, daß die Adressierungsschaltung (28) aus folgenden Bestandteilen gebildet ist:
- einem Lesezähler (21),
- einem Schreibzähler (22),
deren Anfangswerte so gegeben sind, daß die Differenz zwischen der Schreibadresse eines Binärworts und seiner Leseadresse gleich einer gegebenen Anzahl von Perioden des Steuersignals ist,
- einer Umschaltschaltung (29) für die Lese- und Schreibadressen, die an ihrem Eingang die von den beiden Zählern ausgegebenen Adressen enthält und am Ausgang jedem der beiden Speicher nur eine dieser beiden Adressen zuführt.

5. Verzögerungsvorrichtung nach einem der Ansprüche 1, 2, 3 oder 4, dadurch gekennzeichnet, daß die Umschaltschaltung (29) durch folgende Bestandteile gebildet wird:
- ein erstes UND-Gatter (30), das an seinen Eingängen die Adresse des Lesezählers (21) und das Steuersignal mit der Frequenz $f_m$ erhält;

- ein zweites UND-Gatter (31), das an seinen Eingängen die vom Schreibzähler (22) ausgegebene Adresse und das Signal mit der Frequenz $f_m$ nach Durchgang durch eine Invertierschaltung (32) erhält;

- ein ODER-Gatter (33), das an seinen Eingängen die Ausgangssignale der beiden UND-Gatter (30) und (31) erhält und an seinem Ausgang eine der Lese- oder Schreibadressen ausgibt.

6. Verzögerungsvorrichtung nach einem der Ansprüche 1 bis 5, dadurch gekennzeichnet, daß die Mittel (14) zur Wiederherstellung des Signals aus folgenden Bestandteilen gebildet sind:

- einem Schieberegister (34) mit M Stufen, das M parallelgeschaltete Speicherkreise enthält, die von einem einzigen Signal mit der Frequenz $f_m$ gesteuert werden, das mit den vorherigen Steuersignalen synchron ist, wobei die Eingänge der M Speicherkreise jeweils mit den M parallelen Ausgängen der Speichermittel verbunden sind, deren Aufgabe es ist, einen Pufferspeicher zu bilden;

- einem Multiplexer (35), der von einem mit der Frequenz $f_e$ ausgegebenen Signal gesteuert wird, das mit dem vorherigen Steuersignal synchron ist, und dessen M Eingänge jeweils mit den Ausgängen der M Speicherkreise des Schieberegisters (34) verbunden sind und dessen Ausgang das elektrische Signal liefert.

7. Anwendung der Verzögerungsvorrichtung nach einem der Ansprüche 1 bis 6 mit einer Decodierungseinrichtung (7) eines Antwortgeräts, das Teil einer Abstandmeßausrüstung ist, dadurch gekennzeichnet, daß:
- die Frequenz $f_e$ gleich 32 MHz ist,
- die Frequenz $f_m$ gleich 8 MHz ist,
- die Zahl M gleich 4 ist.

**Claims**

1. Device for delaying an electric signal comprising:
- means (12) for the acquisition of the electric signal and sampling said signal at a given frequence $f_e$ for supplying the signal in the form of parallel M bit binary words at a frequency $f_m$ such that:

$$f_m = \frac{f_e}{M};$$

- means (13) for storing the electric signal in the form of M bit binary words, receiving and supplying the information at the frequency $f_m$;
- means (1 4) for the restitution of the electric signal at the frequency $f_m$ from the M bit binary words supplied in parallel by the storing means (13) at the frequency $f_m$;
- characterized in that the storing means (13) supply the binary words to the restitution means (14) with a delay equal to an integer number n of periods $\frac{1}{f_m}$, the storing means (13) comprising means for programming the integer number n, the duration of the delay being thus programmable.

2. Delay device according to claim 1, characterized in that the signal acquisition means (12) are formed by:
- a shift register with M stages, comprising M series connected storing circuits controlled by the same signal of given frequency $f_e$, the function of which is to sample the electric signal and to convert it into binary words each of M bits;
- a buffer memory having M stages, comprising M parallel connected storing circuits controlled by the same signal of the frequency $f_m$ such that:

$$f_m = \frac{f_e}{M},$$

this signal of frequency $f_m$ being further in synchronism with the signal of frequency $f_e$ , and the parallel inputs of the M storing circuits of the buffer memory being respectively connected to the outputs of the M storing circuits of the shift register, this buffer memory temporarily storing each M bit binary word transmitted between the shift register and the storing means of the delay device.

3. Delay device according to claim 1 or 2, characterized in that the means (13) for storing the signal in the form of M bit binary words comprise:
- M addressable random access memories which are connected in parallel and are controlled by the same signal of the frequency $f_m$ which is synchronous with the control signals of the acquisition means, the input of each of the memories being respectively connected to the M parallel outputs of the acquisition means;
- a circuit (28) for addressing said random access memories, said circuit being controlled by the signal of the frequency $f_m$ in synchronism with the preceding control signal, and presenting to each of them and in each period of the control signal a reading address a and a different writing address a';
- a control circuit (24) for the reading and writing of the binary words appearing at the output of the acquisition means (12), controlled by a signal of the frequency $f_m$ which is synchronous with the preceding control signal, and connected to each of the memories.

4. Delay device according to any of claims 1, 2 or 3, characterized in that the addressing circuit (28) is formed by:
- a reading counter (21),
- a writing counter (22),
each of which is initialized to a value such that the difference between the writing address of a binary word and its reading address is equal to a given number of periods of the control signal,
- a change-over circuit (29) for switching the reading and writing addresses, receiving as an input the addresses supplied by the two counters and supplying at its output a single one of these two addresses to each of the memories.

5. Delay device according to any of claims 1, 2, 3 or 4, characterized in that the change-over circuit (29) is formed by:
- a first AND gate (30) receiving at its input the address of the reading counter (21) and the control signal of the frequency $f_m$;
- a second AND gate (31) receiving at its input the address supplied by the writing counter (22) and the signal of the frequency $f_m$ after passing through an inverting circuit (32);
- an OR gate ( 33) receiving at its input the output signals of the two AND gates (30 and 31) and supplying at its output one of the reading and writing addresses.

6. Delay device according to any of claims 1 to 5, characterized in that the signal restitution means (14) are formed by:
- a shift register (34) having M stages, comprising M parallel connected storing circuits each controlled by the same signal of the frequency $f_m$ which is synchronous with the preceding control signals, the inputs of the M storing circuits being respectively connected to the M parallel outputs of the storing means, the function of which is that of a buffer memory;
- a multiplexer (35) controlled by a signal supplied at the frequency $f_e$ in synchronism with the preceding control signal, the M inputs of which are respectively connected to the outputs of the M storing circuits of said shift register (34), and the output of which supplies the electric signal.

7. Application of the delay device according to any of claims 1 to 6 to a decoding device (7) of a transponder forming part of a range finding equipment, characterized in that:
- the frequency $f_e$ is equal to 32 MHz,
- the frequency $f_m$ is equal to 8 MHz,
- the number M is equal to 4.

0 128 055

# FIG_1

INTERROGATEUR

TRANSPONDEUR SOL

INTERROGATION

REPONSE

# FIG_2

| Mode | Précision type | Codage (µs) Interrogations | Réponses | Retard systématique $\tau$ (µs) |
|---|---|---|---|---|
| X | P | 18 | 12 | 56 |
| | N | 12 | 12 | 50 |
| Y | P | 42 | 30 | 62 |
| | N | 36 | 30 | 56 |
| W | P | 30 | 24 | 56 |
| | N | 24 | 24 | 50 |
| Z | P | 27 | 15 | 62 |
| | N | 21 | 15 | 56 |

1

# FIG_3

Antenne

DUPLEXEUR 2

1

RECEPTEUR 3

DETECTION −6 dB 5

VALIDATION EN FREQUENCE 4

DETECTION DAC 6

DECODEUR N/P ET RETARD SYSTEMATIQUE 7

EMETTEUR 8

CODEUR SQUITTER 80

# FIG_4

RETARD 91

92

# FIG_5

DETECTION −6 dB 5

DETECTION DAC 6

DECODEUR 9

RETARD DE COMPENSATION 10

93

RETARD COMPLEMENTAIRE 11

## FIG_6

```
        ┌──────────────┐ ⌐12   ┌──────────────────┐ ⌐13   ┌──────────────┐ ⌐14
    ──→ │ ACQUISITION  │ ──────→│   MEMOIRE DE     │ ──────→│ RESTITUTION  │ ──────→
        └──────────────┘        │ GRANDE CAPACITE  │        └──────────────┘
               ↑                 └──────────────────┘               ↑
              fe                          ↑ fm = fe/M              fe
```

## FIG_7

## FIG_9

# FIG_8

FIG_10